Europäisches Patentamt

European Patent Office

Office européen des brevets

(11) Veröffentlichungsnummer: **0 049 321**
**B1**

(12) **EUROPÄISCHE PATENTSCHRIFT**

(45) Veröffentlichungstag der Patentschrift:
**04.12.85**

(51) Int. Cl.⁴: **H 04 N 11/06,** H 03 J 7/28

(21) Anmeldenummer: **81103864.5**

(22) Anmeldetag: **20.05.81**

(54) **Verfahren zur automatischen Sendersuche bei Fernsehempfängern zum Empfang von PAL- und SECAM-Signalen.**

(30) Priorität: **02.10.80 DE 3037196**

(43) Veröffentlichungstag der Anmeldung:
**14.04.82 Patentblatt 82/15**

(45) Bekanntmachung des Hinweises auf die Patenterteilung:
**04.12.85 Patentblatt 85/49**

(84) Benannte Vertragsstaaten:
**AT BE CH FR LI LU**

(56) Entgegenhaltungen:
**DE - A - 2 522 247**
**DE - A - 2 648 882**

(73) Patentinhaber: **SABA GmbH,**
**Postfach 2060 Hermann-Schwer-Strasse 3,**
**D-7730 Villingen-Schwenningen (DE)**

(72) Erfinder: **Nutz, Werner Ing.-grad.,**
**Mannheimerstrasse 27, D-7730 Villingen-Schwenningen**
**(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Beschreibung

Die Erfindung geht aus von einem Verfahren zur automatischen Sendersuche bei Fernsehempfänger. Es gibt Farbfernsehempfänger, die mit Hilfe von geeigneten Decodern in der Lage sind, Fernsehsender verschiedener Farbfernsehnormen (PAL-SECAM) zu empfangen. Dazu werden die entsprechenden Decoder vor dem Abstimmen des Gerätes auf die betreffende Norm eingeschaltet. Es gibt z. B. eine Schaltung zum automatischen Umschalten eines kombinierten PAL-SECAM-Decoders auf das PAL- oder SECAM-System (DE-OS 2 616 694, DE-OS 2 748 465). Auch sind Schaltungen bekannt für ein elektronisches Kanalwahlsystem für Fernsehgeräte, bei denen zur direkten Anwahl von Fernsehkanälen ein Mikroprozessor, bestehend aus einer Ein-Ausgabeeinheit (PIA) einer Zentraleinheit (CPU), einem nicht verlöschenden elektronischen Speicher (RAM) und einem Festspeicher (ROM), vorgesehen ist, wobei ein Kanaleinsteller die an ihm anstehenden binären Signalen über die PIA-Einheit der CPU-Einheit zuführt, wonach ein dem Kanal entsprechendes Teilerverhältnis ausgerechnet wird, welches einem programmierbaren Teiler in einer Frequenzsynthesizer-Schaltung zugeführt wird, woraus in dieser dann in bekannter Weise eine Abstimmspannung $U_D$ für ein Abstimmaggregat erzeugt wird (DE-AS 2 522 247, DE-OS 2 648 882, Grundig Technische Information, 1979, Heft 1, S. 20—24).

Bei den bisher üblichen Farbfernsehempfängern zum Empfang von PAL-SECAM-Signalen muß der entsprechende Decoder eingeschaltet werden. Dies geschieht z. B. mit Hilfe einer Schaltspannung, die bei Betätigen einer Progammwahltaste an den entsprechenden Decoder angelegt wird. Bei PAL-SECAM-Empfängern wird ganz bestimmten Ortstasten einer Ortstastengruppe ein Schaltkontakt zugeordnet, während beim Betätigen einer beliebigen anderen Ortstaste der Empfänger auf PAL-Betrieb geschaltet ist. Nachteilig hierbei ist jedoch, daß der Benutzer wegen der unterschiedlichen Farbfernseh-Normen einen SECAM-Sender beim Abstimmen gar nicht identifizieren kann, wenn er nicht vorher eine nur einem SECAM-Sender zugeordnete Ortstaste betätigt hat. Das heißt aber, daß der Benutzer des Gerätes vor dem Abstimmvorgang wissen muß, ob in dem betreffenden Kanal ein SECAM-Sender liegt oder nicht, damit er die richtige Auswahl einer Taste aus der Ortstastengruppe vornimmt. Auch bei einem automatischen Sendersuchlauf erhält die Suchlaufschaltung keinen Stopp-Impuls wenn nicht der dem eingeschalteten Kanal entsprechende Decoder (PAL- oder SECAM) eingeschaltet wurde.

Der Erfindung liegt daher die Aufgabe zugrunde, für Farbfernsehempfänger mit einem umschaltbaren PAL-SECAM-Decoder, welcher mit einem automatischen Sendersuchlauf ausgerüstet ist, die automatische Sendersuche gleichermaßen für die Auswahl von PAL- oder SECAM-Sendersignalen geeignet zu machen ohne daß vorher separat der entsprechende PAL- oder SECAM-Decoder eingeschaltet werden muß.

Diese Aufgabe wird durch die in den Ansprüchen gekennzeichneten Maßnahmen gelöst.

Durch die erfindungsgemäße Verfahrensweise wird der Vorteil erzielt, daß bei Empfangsmöglichkeiten von PAL- oder SECAM-Signalen und einem Abspeichern der Abstimmdaten in einem nicht flüchtigen Speicher diese auf jeden beliebigen Speicherplatz abgelegt werden können und daß der Benutzer des Farbfernsehempfängers bei der Abstimmung vor dem Einspeichern keine Überlegungen anstellen muß, ob in dem eingestellten Kanal ein PAL- oder ein SECAM-Sender empfangen wird.

Nachstehend soll das Verfahren mit Hilfe der Zeichnung beschrieben werden, wobei

Fig. 1 ein Blockschaltbild eines Farbfernsehempfängers zeigt, mit welchem das angemeldete Verfahren durchgeführt werden kann;

Fig. 2 die einzelnen Verfahrensschritte aufzeichnet, die in Form eines Programms dem im Farbfernsehgerät eingebauten Mikroprozessor eingegeben werden können und in

Fig. 3 das Verfahren in einem zeitlichen Ablaufdiagramm verdeutlicht wird.

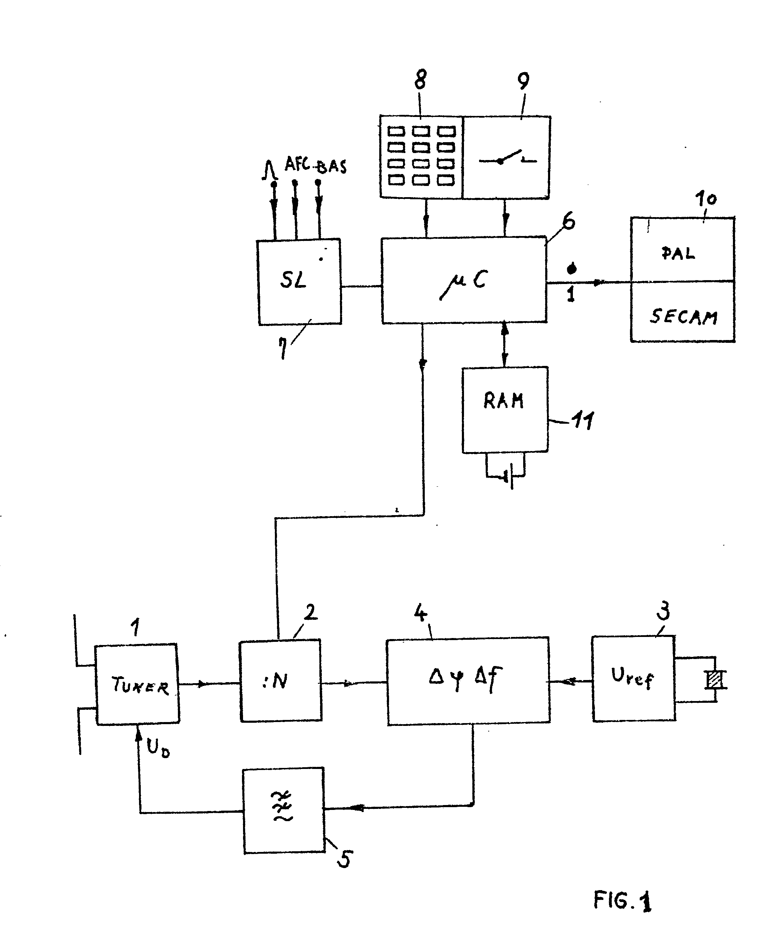

In Fig. 1 ist das Empfangsteil (Tuner) 1 gezeigt, das auf einem beliebigen Pal- oder SECAM-Sender abstimmbar ist. Die genaue Abstimmung erfolgt in bekannter Weise mittels einer Frequenzsynthesizer-Schaltung z. B. einer Phaselocked-loop (PLL)-Schaltung, bestehend aus einem die Oszillatorfrequenz des Tuners 1 teilenden programmierbaren Teiler 2, einer Referenzfrequenz-Quelle 3, einem Frequenz- und Phasendetektor 4 sowie aus eienm Tiefpaßfilter 5, welchem die Abstimmspannung $U_D$ für den Tuner 1 entnommen wird. Nach Eingabe einer Kanalzahl K berechnet der Mikroprozessor 6 aus dieser das entsprechende Teilungsverhältnis N für den Kanalanfang und gibt dieses über einen I/O-Port an den programmierbaren Teiler 2. Dann wird automatisch durch eine Suchlaufschaltung 7 ein Suchlauf gestartet, der in bestimmten Frequenzschritten die Abstimmung verändert bis durch einen Stopimpuls, ausgelöst durch das gleichzeitige Vorhandensein von Zeilenrückschlagimpuls, Zeilensynchronimpuls und AFC-Spannnung der Suchlauf beendet wird und der aktuell durch den Mikroprozessor ermittelte Wert für das Teilungsverhältnis N ausgegeben wird. Gleichzeitig wird vom Mikroprozessor 6 der PAL-SECAM-Decoder 10 gesteuert. Das ermittelte Teilungsverhältnis N wird digital zusammen mit dem Steuerbit für die PAL-SECAM-Umschaltung in einem nicht flüchtigen Speicher (RAM) 11 auf einem beliebigen Platz abgespeichert. Dadurch wird bei einem späteren Senderaufruf über die Ortstasten mit Hilfe des abgespeicherten Steuerbit automatisch auch der Decoder 10 entsprechend umgeschaltet. Durch die Abspeicherung dieses zusätzlichen Steuerbit ist eine Beschränkung der Auswahl von für den Empfang von SECAM-Sendern vorgesehenen Ortstasten nicht mehr notwendig.

Der automatische Suchlauf kann entweder durch eine direkte Kanaleingabe mit Hilfe eines Tastenfeldes 8 innerhalb eines bestimmten Kanals oder durch einen Tastenkontakt 9 als kontinuierlicher Suchlauf über alle Frequenzbänder von Kanal zu Kanal in aufsteigender Reihenfolge eingeleitet werden.

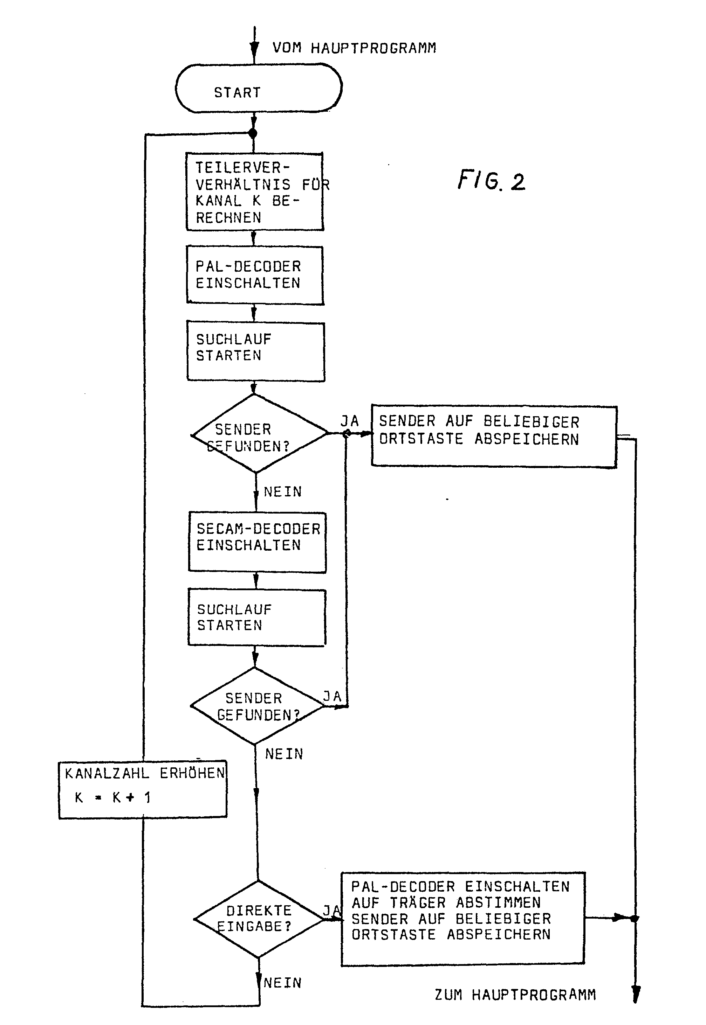

In Fig. 2 sind in einem Ablaufplan die einzelnen Verfahrensschritte eingezeichnet. Hier wird davon ausgegangen, daß das beschriebene Verfahren innerhalb eines mikroprozessorgesteuerten Ablaufs als Unterprogramm eingebaut ist. Zunächst wird das Verfahren entweder durch Betätigen des Tastenkontaktes 9 oder durch eine direkte Kanaleingabe eingeleitet. Dann wird das Teilerverhältnis für den entsprechenden Kanal berechnet und der PAL-Decoder eingeschaltet und darauf der Kanalsuchlauf gestartet. Wird durch einen Stop-Impuls ein PAL-Sender erkannt, so kann er anschließend auf einem beliebigen Speicherplatz im nicht flüchtigen Speicher abgespeichert werden. Die Information für die Einschaltung des PAL-Decoders wird ebenfalls gespeichert. Falls kein PAL-Sender festgestellt wurde, wird automatisch auf den SECAM-Decoder umgeschaltet und der Suchlauf automatisch von Anfang des soeben abgesuchten Kanalbereichs erneut gestartet. Wenn dann ein SECAM-Sender gefunden wurde, wird dieser auf einen beliebigen Speicherplatz zusammen mit der Umschaltinformation für den SECAM-Decoder abgespeichert. Falls auch hierbei kein Sender gefunden wurde, wird automatisch festgestellt, ob der Suchlauf durch eine direkte Kanaleingabe gestartet wurde. In diesem Fall wird wieder auf den PAL-Decoder umgeschaltet, und auf die genormte Trägerfrequenz automatisch abgestimmt, die dann abgespeichert werden kann. Handelt es sich jedoch nicht um eine direkte Kanaleingabe, dann wird der Suchlauf auf dem nächst höheren Kanalbereich wiederholt mit dem gleichen Ablauf wie beschrieben.

Nach Beendigung des Speichervorgangs geht das Verfahren wieder zurück in den normalen Verfahrensablauf des mikroprozessorgesteuerten Farbfernsehempfängers.

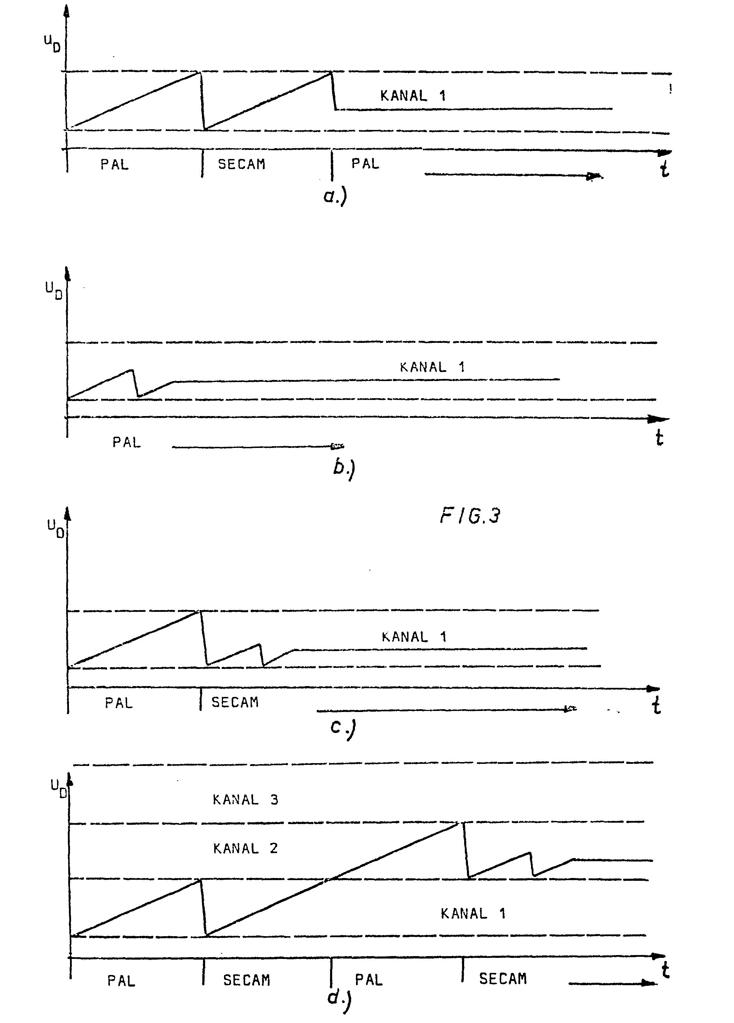

In Fig. 3a bis d sind verschiedene zeitliche Diagramme des Suchlaufs aufgezeichnet.

In Fig. 3a wird der Suchlauf durch Eingabe eines bestimmten Kanals gestartet. Es wird zunächst kein PAL-Sender gefunden — auch nach Umschalten auf den SECAM-Decoder und erneutem Start wird kein Sender gefunden, so daß anschließend auf die genormte Trägerfrequenz des PAL-Senders im betreffenden Kanal eingestellt wird.

In Fig. 3b wird nach dem ersten Suchvorgang ein PAL-Sender gefunden und dieser abgespeichert.

In Fig. 3c wird erst nach erneutem Suchlauf ein SECAM-Sender gefunden und dieser abgespeichert.

In Fig. 3d wird nach dem Start eines kontinuierlichen Suchlaufs beginnend beim Kanal der niedrigsten Frequenz abwechselnd nach PAL-SECAM-Sendern gesucht, bis er auf einen Sender in einem Kanal stößt, der dann beliebig abspeicherbar ist.

## Patentansprüche

1. Verfahren zur automatischen Sendersuche bei Farbfernsehempfängern, die mittels eines umschaltbaren PAL-SECAM-Decoder Fernsehsendungen der PAL- und SECAM-Norm empfangen können, wobei die Abstimmspannungen für ein Abstimmaggregat mittels einer Frequenzsynthesizer-Schaltung (2,3,4,5) erzeugt werden, die in einem elektronischen Speicher (11) in Form von Bit-Kombinationen abgelegt sind, aus denen bestimmte Teilerverhältnisse (N) für einen Frequenzteiler (2) in der Frequenzsynthesizer-Schaltung (2, 3, 4, 5) gebildet werden und bei Erreichen eines Fernsehsignals ein Stoppsignal erzeugt wird, wonach die sich ergebende Abstimminformation als Bitwort auf einen beliebigen Speicherplatz des Speichers (11) abgelegt werden kann, dadurch gekennzeichnet, daß eine Steuerschaltung vorgesehen ist, die zunächst den PAL-Decoder in Betrieb setzt, worauf der Suchlauf an einem Kanalanfang beginnt, der bei Erreichen eines PAL-Sendersignals automatisch angehalten wird und falls kein Stoppsignal bis zum Erreichen der Kanalgrenze eintrifft, die Steuerschaltung den PAL-Decoder aus- und den SECAM-Decoder einschaltet, worauf der Suchlauf am Kanalanfang erneut automatisch für das Auffinden eines SECAM-Sendersignals gestartet wird, und daß bei Erreichen eines PAL- oder SECAM-Sendersignals die ihnen entsprechende Abstimminformation zusammen mit dem Steuerbit für die PAL-SECAM-Umschaltung im Speicher (11) abgelegt wird.

2. Verfahren nach Anspruch 1, dadurch gekennzeichnet, daß bei einem kontinuierlichen Sendersuchlauf von Kanal zu Kanal diese Kanäle in aufsteigender Reihenfolge abwechselnd im PAL-SECAM-Mode abgesucht werden.

3. Verfahren nach den Ansprüchen 1 und 2, dadurch gekennzeichnet, daß bei direkter Kanaleingabe bei nicht vorhandenen Sendersignalen in einem Kanal automatisch der PAL-Decoder (10) eingeschaltet und auf die genormte Trägerfrequenz des betreffenden Kanals abgestimmt wird und das entsprechende Teilerverhältnis (N) zusammen mit dem Steuerbit für PAL-Empfang im Speicher (11) abgelegt wird.

## Claims

1. Process for automatic station finding in colour-TV-receivers, which can receive TV-broadcastings of the PAL- and SECAM-Standard by means of a switchable PAL-SECAM-Decoder, whereby the tuning-voltages for a tuner is being generated by a frequency-synthesizercircuit (2, 3, 4, 5), which are allocated in an electronic memory (11) in the form of Bit-combinations, out of which definitve divider proportions (N) for a frequency divider (2) are formed in the frequency-synthesizer-circuit (2, 3, 4, 5) and at attaining of a TV-signal a stop-Signal ist generated, whereafter the achived tuning information can be allocated as Bit-word at an arbitrary storage position of the memory (11), characterized in that a control circuit is provided, which firstly activates the PAL-decoder, whereafter the search starts at one channel-beginning, which is stopped automatically if a PAL-station signal is attained out if no stop-signal arrives until the end of the channel, the control circuit switches the PAL-decoder off and the SECAM-decoder on, whereafter the search starts again automatically at the beginning of the channel for the finding of a SECAM-station signal, and that at attaining of a PAL- or SECAM-station signal the appropriate tuning information together withe the control-Bit for the switching of PAL to SECAM is being allocated in the memory (11).

2. Process according to claim 1, characterized in that at a continuous search from channel to channel all these channels are being searched in rising sequence in the PAL-SECAM-mode.

3. Process according to the claims 1 and 2, characterized in that at direct channel-input with not available station signals automatically the PAL-decoder (10) will be switched on and tuned to the standardized carrier frequency of the concerning channel and the corresponding divider proportion (N) together with the control-Bit for PAL-reception will be allocated in the memory (11).

**Revendications**

1. Procédé pour la recherche automatique d'émetteurs dans des téléviseurs en couleurs qui, au moyen d'un décodeur commutable PAL/SECAM, peuvent recevoir des émissions de télévision de la norme PAL et SECAM, où les tensions de réglage pour un bloc d'accord sont engendrées au moyen d'un circuit synthétiseur de fréquence (2, 3, 4, 5) ces tensions se trouvant dans une mémoire (11) électronique sous forme de combinaisons de bits à partir desquelles se forment des rapports de diviseurs (N) déterminés pour un diviseur de fréquence (2) dans le montage synthétiseur de fréquence (2, 3, 4, 5), et à partir desquelles est engendré un signal d'arrêt quand un signal de télévision est atteint, après quoi l'information d'accord sous forme de mot-binaire peut être disposée dans une case quelconque de la mémoire (11), caractérisé en ce qu'est prévu un circuit de commande, qui met d'abord le décodeur PAL en service, sur quoi la recherche commence à un début de canal, s'arrête automatiquement en parvenant à un signal d'émetteur PAL, si aucun signal d'arrêt ne se produit quand est atteint la limite du canal, le circuit de commande se décroche du décodeur PAL et se connecte au décodeur SECAM, après quoi la recherche est déclenchée automatiquement à nouveau au début du canal pour trouver un signal d'émetteur SECAM et en ce que, quand un signal d'émission PAL ou SECAM est obtenu, l'information d'accord qui leur correspond est disposée, dans la mémoire (11), avec le bit de commande pour la commutation PAL-SECAM.

2. Procédé selon la revendication 1, caractérisé en ce que, avec une recherche continue d'un canal à l'autre, ces canaux sont explorés par ordre croissant, alternativement en mode PALSECAM.

3. Procédé selon les revendications 1et 2, caractérisé en ce que, avec l'introduction directe du canal pour des signaux d'émission absents, le décoder PAL (10) est mis en circuit automatiquement dans un canal, et est accordé sur la fréquence porteuse normalisée du canal concerné, et le rapport de division correspondant (N) est disposé ensemble avec le bit de commande pour la réception PAL dans la mémoire (11).

FIG. 1

VOM HAUPTPROGRAMM

START

*FIG. 2*

TEILERVER-
VERHÄLTNIS FÜR
KANAL K BE-
RECHNEN

PAL-DECODER
EINSCHALTEN

SUCHLAUF
STARTEN

SENDER
GEFUNDEN?  —JA→  SENDER AUF BELIEBIGER
ORTSTASTE ABSPEICHERN

NEIN

SECAM-DECODER
EINSCHALTEN

SUCHLAUF
STARTEN

SENDER
GEFUNDEN?  —JA→

NEIN

KANALZAHL ERHÖHEN
K = K + 1

DIREKTE
EINGABE?  —JA→  PAL-DECODER EINSCHALTEN
AUF TRÄGER ABSTIMMEN
SENDER AUF BELIEBIGER
ORTSTASTE ABSPEICHERN

NEIN

ZUM HAUPTPROGRAMM

7

FIG.3

a.)

b.)

c.)

d.)